# EUROPEAN PATENT APPLICATION

(11) **EP 1 670 060 A1**
(43) Date of publication of application: **14.06.2006**
(21) Application number: 04788006.7
(22) Date of filing: 22.09.2004
(51) Int. Cl.: H01L 27/108, H01L 27/04, H01L 21/8242, H01L 21/822

(54) **SEMICONDUCTOR DEVICE, SEMICONDUCTOR DEVICE MANUFACTURING METHOD, SEMICONDUCTOR DEVICE MANUFACTURING APPARATUS, AND COMPUTER RECORDING MEDIUM**

(30) Priority: 26.09.2003 JP 2003334479
(71) Applicant: TOKYO ELECTRON LIMITED, Minato-ku, Tokyo 107-8481 (JP)
(72) Inventor: SASAKI, Masaru, c/o TOKYO ELECTRON AT LIMITED, Amagasaki-shi, Hyogo 6600891 (JP)
(74) Representative: HOFFMANN EITLE
(86) International application number: PCT/JP2004/013823
(87) International publication number: WO 2005/031869

(57) **Abstract**

An object of the present invention is to prevent an increase in film thickness and inhibit a reduction in capacity of a capacitor.

In a semiconductor device having a capacitor, the capacitor includes a lower electrode, an upper electrode, and an insulating film interposed between the lower electrode and the upper electrode. A surface of the lower electrode on an insulating layer side is nitrided. If the lower electrode is made of polysilicon, nitriding the surface thereof increases oxidation resistance at the time of heat treatment in a post process. Particularly in a DRAM, the capacity of the capacitor is large, and therefore, this effect is significant. Further, leakage current inside the capacitor is also reduced.

## Description

### [Technical Field]

The present invention relates to a semiconductor device having a capacitor which is formed by applying plasma processing, a manufacturing method thereof, a semiconductor manufacturing apparatus capable of performing the plasma processing used for forming the capacitor, and a computer recording medium.

### [Background Art]

A DRAM as a semiconductor device has, in its memory cell, a MOS transistor and a capacitor storing charges for memory. In recent years, in accordance with the miniaturization of a semiconductor device, size shrinkage of the transistor and the capacitor in the semiconductor device is being demanded. Since the capacity of a capacitor is proportional to its area and inversely proportional to its thickness, there is a limit to reduction in thickness of the capacitor.

The structures often adopted as a capacitor are a MIM (Metal Insulator Metal) structure and a MIS (Metal Insulator Semiconductor) structure. For a semiconductor layer (lower electrode) of the MIS structure, used is, for example, polysilicon.

Processes for forming the above-described capacitor structure includes a heat treatment process after the lower electrode of polysilicon or the like and a capacitive film are formed. When heat-treated, a SiO₂ layer is formed on the polysilicon electrode since its surface oxidizes. As a result, an apparent dielectric constant of an insulating film constituting the capacitor lowers, resulting in a reduced capacity.

On the other hand, for a peripheral circuit of a logic device, titanium nitride (TiN) is sometimes used instead of the lower electrode made of a polysilicon material. When the titanium nitride as the lower electrode of the capacitor is heat-treated, its surface oxidizes similarly to polysilicon. As a result, TiO is formed, which increases conductor resistance. Or, a problem occurred that an apparent thickness of the insulating film constituting the capacitor increased, resulting in a reduced capacity.

Japanese Patent Application Laid-open No. 2001-274148 discloses a method of forming a silicon nitride film on a silicon oxide film by plasma processing.

Patent Document 1: Japanese Patent Application Laid-open No. 2001-274148

### [Disclosure of the Invention]

### [Problems to Be Solved by the Invention]

The present invention was made in consideration of the above-described circumstances, and an object thereof is to provide a semiconductor device in which increase in film thickness and reduction in capacity of a capacitor can be inhibited, and to provide a manufacturing method and a manufacturing apparatus thereof. It is another object to prevent leakage current in a capacitor.

### [Means for Solving the Problems]

In order to achieve the objects stated above, a first aspect of the present invention is a semiconductor device having a capacitor, characterized in that: the capacitor includes a lower electrode, an upper electrode, and an insulating film interposed between the lower electrode and the upper electrode; and a surface of the lower electrode on an insulating layer side is nitrided.

A second aspect of the present invention is a manufacturing method of a semiconductor device including the steps of: forming a lower electrode for a capacitor on a semiconductor substrate; nitriding a surface of the lower electrode; forming an insulating film on the lower electrode; and forming an upper electrode on the insulating film.

A third aspect of the present invention is an apparatus used in manufacturing steps of a capacitor having an upper electrode, a lower electrode, and an insulating film formed between these electrodes, the apparatus including: a process vessel housing a semiconductor substrate to be processed; a gas supply means for supplying gas appropriate for processing into the process vessel; and a microwave supply means for supplying a microwave into the process vessel in order to excite a plasma. Further, in order to form a nitride film on a surface of the lower electrode, the gas supply means supplies nitrogen gas into the process vessel after the semiconductor substrate on which the lower electrode is formed is loaded in the process vessel.

In each of the aspects of the present invention, if the lower electrode is made of polysilicon, nitriding its surface improves oxidation resistance at the time of heat treatment in a post process. Generally, since the capacity of a capacitor is large in a DRAM, applying the present invention to a capacitor of a DRAM makes the effect more prominent.

Further, if titanium nitride is used as the lower electrode, a surface of the titanium nitride is further nitrided, so that a nitrogen-rich layer is formed. This improves oxidation resistance at the time of heat treatment in a post process, similarly to the case of the polysilicon lower electrode.

The steps of forming a lower electrode for a capacitor on a semiconductor substrate, nitriding a surface of the lower electrode, forming an insulating film on the lower electrode, and forming an upper electrode on the insulating film are carried out in, for example, a semiconductor manufacturing apparatus. These steps are executed by a computer controlling the semiconductor manufacturing apparatus based on software that a computer recording medium has.

### [Effect of the Invention]

In the present invention, nitridation processing is applied to a surface of a lower electrode of a capacitor, so that not only oxidation resistance is improved but also leakage current in the capacitor is reduced. As a result, an apparent dielectric constant is prevented from lowering and the thickness of an insulating film is allowed to be thick.

### [Brief Description of the Drawings]

[FIG 1] An explanatory view of a cross section showing a structure of a capacitor according to a first embodiment of the present invention.
[FIG. 2] A flow showing an example of a manufacturing method of a semiconductor device of the present invention.
[FIG. 3] Cross-sectional view showing a structure of a plasma processing apparatus according to the present invention.
[FIG. 4] A graph showing an operation/effect of the capacitor according to the first embodiment.
[FIG. 5] An explanatory view of a cross section showing a structure of a capacitor according to a second embodiment of the present invention.
[FIG. 6] Process views showing part of manufacturing processes of the capacitor according to the second embodiment, FIG. 6(A) showing a state where titanium nitride is deposited and FIG. 6(B) showing a state where a nitrogen-rich layer is formed by plasma nitridation processing.
[FIG. 7] A graph showing an operation/effect of the capacitor according to the second embodiment.
[FIG.8] A graph showing an operation/effect of the capacitor according to the second embodiment.
[FIG. 9] A graph showing pressure dependency of film thickness in plasma nitridation processing.

### [Explanation of Codes]

- 10: capacitor
- 11: silicon substrate
- 12: lower electrode
- 14: insulating film
- 16: upper electrode
- 18: nitride layer
- 20: plasma processing apparatus
- 21: plasma process vessel
- 21A, 21B: exhaust port
- 22: substrate support table
- 28: waveguide
- 27: gas supply port
- W: silicon wafer

### [Best Mode for Carrying out the Invention]

Hereinafter, the present invention will be described, taking manufacture of a capacitor in a DRAM as an example. Each of a plurality memory cells forming the DRAM has a structure including one MOS transistor, one capacitor, and element isolating regions. The MOS transistor includes, for example, N-doped source electrode and drain electrode on a P-type silicon substrate, a gate insulating film, and a gate electrode. The drain electrode is connected to a bit line. The gate electrode is connected to a word line. A protective oxide film is formed around the gate electrode portion.

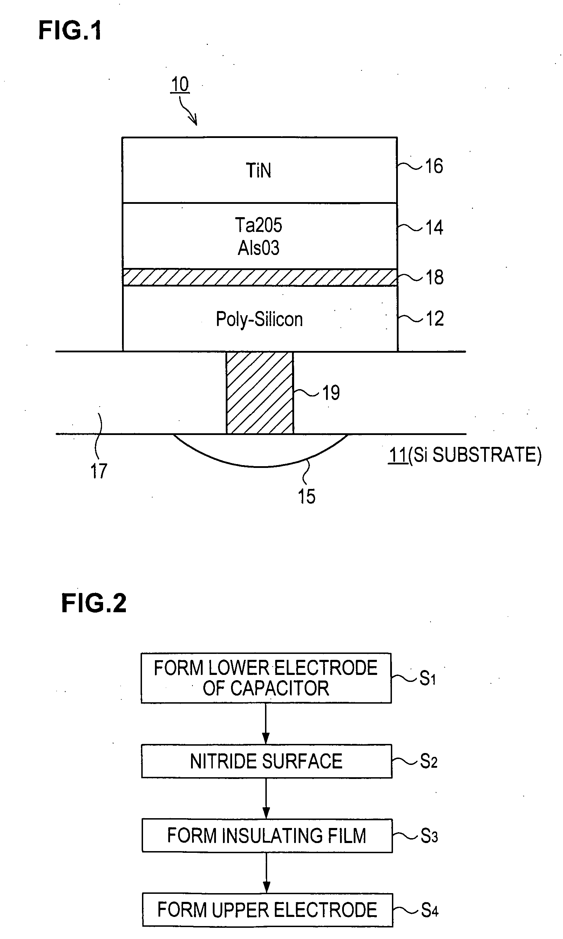

FIG. 1 (A) shows a structure of a capacitor 10 according to a first embodiment of the present invention. The capacitor 10 includes an interlayer insulating film 17 formed on a silicon substrate 11, a lower electrode 12 formed on the interlayer insulating film 17, an insulating film 14 formed on the lower electrode 12, and an upper electrode layer 16 formed on the insulating film 14. The upper electrode layer 16 is a metal layer of TiN or the like, and the lower electrode 12 is made of polysilicon. The lower electrode 12 has a nitride layer 18 on a surface thereof in contact with the insulating film 14. The capacitor 10 is electrically connected to a source part 15 of a MOS transistor by polysilicon 19.

Next, processes for forming the capacitor 10 will be described based on FIG. 2. First, a contact hole is opened in the interlayer insulating film 17 by etching, and polysilicon is deposited by a CVD method or the like to form the lower electrode 12 (Step S1). Thereafter, the nitride layer 18 (polysilicon nitride film) is formed on the surface of the lower electrode 12 by plasma nitridation processing (Step S2). Thereafter, the insulating film 14 is formed on the nitride film 18 (Step S3). Further, the upper electrode layer 16 is formed (Step S4). Thereafter, for example, etching necessary to make a rugged shape is applied in order to increase a surface area, whereby the capacitor 10 is formed.

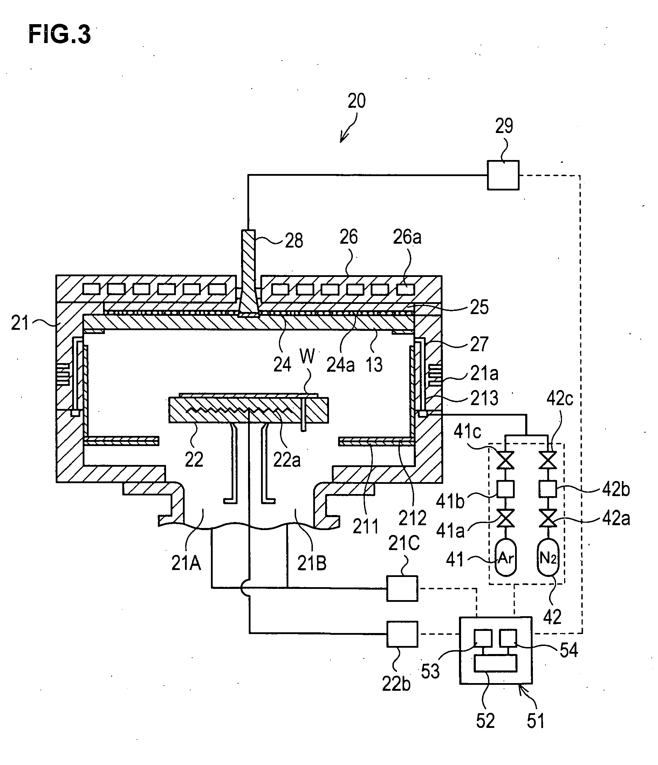

FIG. 3 shows an overview of a structure of a semiconductor manufacturing apparatus (plasma processing apparatus) 20 used for the plasma nitridation processing of the present invention. The semiconductor manufacturing apparatus 20 has a process vessel 21 including a substrate support table 22 supporting a silicon wafer W as a substrate to be processed. The substrate support table 22 has therein a heater 22a, so that it can heat a silicon wafer W to a desired temperature when supplied with power from a power source 22b.

Gas in the process vessel 21 is exhausted from exhaust ports 21A and 21 B via an exhaust pump 21C. A gas baffle plate (partition plate) 211 made of aluminum is disposed around the substrate support table 22. A quartz cover 212 is provided on an upper surface of the gas baffle plate 211.

Above the process vessel 21 in the apparatus, an opening part corresponding to the silicon wafer W on the substrate support table 22 is provided. This opening part is closed by a dielectric plate 23 made of quartz or Al₂O₃. A plane antenna 24 is disposed on an upper side of the dielectric plate 23 (on an outer side of the process vessel 21). The plane antenna 24 has a plurality of slots 24a for allowing an electromagnetic wave supplied from a waveguide to pass therethrough. A retardation plate 25 and the waveguide 28 are disposed on a further upper side (outer side) of the plane antenna 24. A cooling plate 26 is disposed on an outer side of the process vessel 21 so as to cover an upper side of the retardation plate 25. A refrigerant path 26a through which a refrigerant flows is provided inside the cooling plate 26.

In an inner sidewall of the process vessel 21, provided is a gas supply port 27 through which gas is introduced at the time of the plasma nitridation processing. In this embodiment, as process gas supply sources, an argon gas supply source 41 and a nitrogen gas supply source 42 are prepared, and these gas supply sources are connected to the gas supply port 27 via valves 41a, 42a, mass flow controllers 41b, 42b for flow rate adjustment, and valves 41c, 42c, respectively. Further, a refrigerant path 21a is formed inside the inner wall of the process vessel 21 so as to surround the whole vessel.

The semiconductor manufacturing apparatus 20 includes an electromagnetic wave generator (magnetron) 29 generating a several GHz electromagnetic wave for plasma excitation. The microwave generated by the electromagnetic wave generator 29 propagates through the waveguide 28 to be introduced to the process vessel 21.

The semiconductor manufacturing apparatus 20 is controlled by a controller 51. The controller 51 has a central processing unit 52, a support circuit 53, and a recording medium 54 containing relevant control software. The controller 51 controls, for example, the supply, stop, flow rate adjustment of the gas supplied through the gas supply port 27, temperature adjustment of the heater 22a, the exhaust by the exhaust pump 21C, the electromagnetic wave generator 29, and so on, and performs necessary control operations in processes in which plasma processing is executed in the semiconductor manufacturing apparatus 20.

As the central processing unit 52 of the controller 51, a processor of a general-purpose computer is usable. Examples usable as the storage medium 54 are various types of recording media such as a RAM, a ROM, a flexible disk, and a hard disk. Further, the support circuit 53 is connected to the central processing unit 52 in order to support the processor in various ways. A major part of the semiconductor manufacturing apparatus 20 is structured as described above.

For forming the nitride layer 18 on the surface of the lower electrode 12 by the plasma nitridation processing, a wafer W in which the lower electrode 12 is formed above the silicon substrate 11 is set on the substrate support table 22. Thereafter, air inside the process vessel 21 is exhausted through the exhaust ports 21A, 21B. The inside of the process vessel 21 is set to a predetermined process pressure. Inert gas, for example, argon gas and nitrogen gas are supplied through the gas supply port 27.

The microwave with a several GHz frequency generated by the electromagnetic wave generator 29 is supplied to the process vessel 21 through the waveguide 28. The microwave is introduced into the process vessel 21 via the plane antenna 24 and the dielectric plate 23. Then, a plasma is excited by the microwave, so that a nitrogen radical is generated. By the high-density plasma generated by the microwave excitation in the process vessel 21, the nitride layer 18 is produced on the surface of the lower electrode 12.

Thereafter, the insulating film 14 is formed on the lower electrode 12. This insulating film 14 is, for example, a silicon oxide film. Next, the upper electrode layer 16 is formed on the insulating film 14, whereby the capacitor 10 is constructed. Heat treatment is applied in the process of forming the insulating film 14 or in the process of forming the upper electrode 16, but since the nitride layer 18 is formed on the lower electrode 12, the oxidation of the upper surface of the lower electrode 12 is effectively inhibited.

Incidentally, for the upper electrode 16, polysilicon is also usable instead of a metal material such as titanium nitride or aluminum. A silicon oxynitride film, tantalum oxide, aluminum oxide, or the like instead of the silicon oxide film is usable as the insulating film 14.

Next, plasma nitridation processing was actually applied on a silicon substrate to verify oxidation resistance of the nitride layer at the time of the heat treatment. Table 1 shows the result.

**[Table 1]**

| NO. | Ar/N2 (sccm) | PLASMA OUTPUT (W) | PROCESS PRESSURE (Pa) | PROCESS TEMPERATURE (°C) | PROCESS TIME (sec) |
|---|---|---|---|---|---|
| 1 | 1000/40 | 3500 | 67 | 400 | 30 |
| 2 | 1000/40 | 3500 | 67 | 400 | 120 |
| 3 | 1000/40 | 3500 | 67 | 400 | 300 |
| 4 | RAPID THERMAL NITRIDATION PROCESSING | | | | 180 |

No. 1 to No. 3 are silicon substrates having undergone the plasma nitridation processing based on the present invention. For the samples based on the present invention, mixed gas of argon gas and nitrogen gas was used as process gas. A flow rate ratio thereof was 1000/40 (sccm) for all the samples. For all the samples, plasma output at the time of the plasma processing was 3500W, process pressure was 67 Pa, and process temperature was 400 °C. No. 1 to No. 3 are different in plasma processing time, the time for No. 1 being 30 seconds, the time for No. 2 being 120 seconds, and the time for No. 3 being 300 seconds. No. 4 shows, as a comparative example, data of a silicon substrate having undergone rapid thermal nitride film processing.. The processing time thereof was 180 seconds. Seven samples were prepared for each of No. 1 to No. 4. The samples of No. 1 to No. 4 were subjected to thermal oxidation processing at a temperature within a range from 600°C to 900°C after being subjected to the aforesaid nitridation processing.

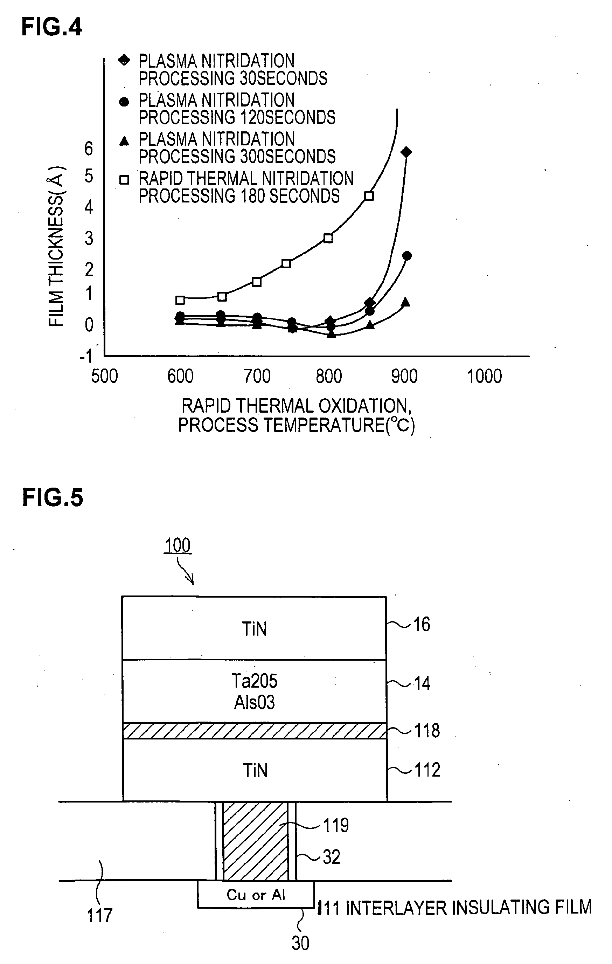

FIG. 4 shows the effect given to a nitride film in the experiment shown in Table 1. The vertical axis represents an incremental amount of optical film thickness, in angstrom unit, by the oxidization of the nitride film. The horizontal axis represents process temperature, in centigrade unit, of the rapid thermal oxidation processing. Each point in the graph represents an incremental amount of the nitride film by the thermal oxidation at the temperature of the thermal oxidation processing. As is seen from this graph, the samples having undergone the plasma nitridation processing exhibit a relatively smaller incremental amount of the optical film thickness than the samples having undergone the rapid thermal nitridation processing, and are less effected by the thermal oxidation. It is also seen that the incremental amount of the optical film thickness is smaller as the time of the plasma nitridation processing is longer. Therefore, it can be said that the nitride film becomes thicker as the time of the plasma nitridation processing is longer and as the nitride film resulting from the plasma nitridation processing is thicker, the effect of the thermal oxidation is smaller and a higher oxidation resistance can be obtained.

Next, a second embodiment of the present invention will be described. This embodiment uses titanium nitride instead of polysilicon as a lower electrode 112 of a capacitor. FIG. 5 shows its structure. Note that in the description of this embodiment, the same reference numerals are used to designate components the same as or corresponding to those of the above-described first embodiment, and repeated description will be omitted.

A capacitor 100 is structured such that a via hole is opened by etching on an interlayer insulating film 117 formed on an interlayer insulating film 111, a barrier metal 32 and a via metal 119 are buried therein, and a lower electrode layer 112 made of titanium nitride, an insulating film 14 formed on the lower electrode layer 112, and an upper electrode 16 formed on the insulating film 14 are formed by CVD. The upper electrode 16 is a metal layer of TiN or the like. In the lower electrode 112, a nitrogen-rich layer 118 is formed on a surface thereof in contact with the insulating film 14. The capacitor 100 is connected to an Al wiring or a Cu wiring 30, and is finally electrically connected to a source electrode of a MOS transistor.

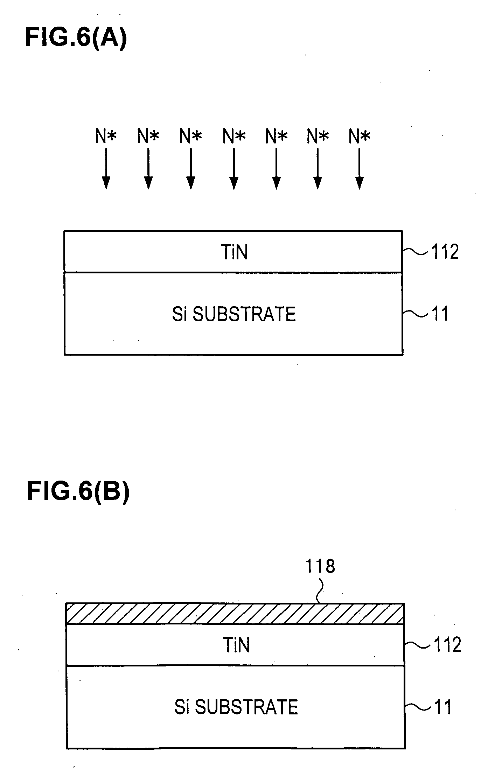

For forming the capacitor 100, the via hole is opened by etching the interlayer insulating film 117 which is formed on the interlayer insulating film 111 by a CVD method or the like, the barrier metal 32 and the via metal 119 are buried therein, and titanium nitride is deposited thereon, whereby the lower electrode 112 is formed. Thereafter, the nitrogen-rich layer 118 is formed on the surface of the lower electrode 112 by plasma nitridation processing (see FIGs. 6(A), (B)).

Part of the manufacturing processes of the capacitor 100 according to this embodiment is performed by the plasma processing apparatus 20 shown in FIG 2. For making the surface of the lower electrode 112 rich in nitrogen, a wafer W in which the lower electrode 112 is formed on a silicon substrate 11 is set on the substrate support table 22 of the plasma processing apparatus 20. Thereafter, air in the process vessel 21 is exhausted through the exhaust ports 21A, 21B. The inside of the process vessel 21 is set to a predetermined process pressure. Inert gas and nitrogen gas are supplied through the gas supply port 27.

Meanwhile, a microwave with a several GHz frequency generated by the electromagnetic wave generator is supplied to the process vessel 21 through the waveguide 28. The microwave is introduced into the process vessel 21 via the plane antenna 24 and the dielectric plate 23. Then, this microwave excites a plasma to generate a nitrogen radical. By the high-density plasma generated by the microwave excitation in the process vessel 21, the further nitrided layer 11-8 is produced here on the surface of the lower electrode 112. Nitrogen is distributed on the whole lower electrode 112 since it is made of titanium nitride. The nitrogen is doped by the plasma nitridation processing, whereby the nitrogen-rich layer 118 is formed. Therefore, the nitrogen-rich layer 118 is a layer containing a larger amount of nitrogen than other areas in the lower electrode 112.

Thereafter, the insulating film 14 is formed on the lower electrode 112. This insulating film 14 is, for example, a silicon oxide film. Next, the upper electrode 16 is formed on the insulating film 14, whereby the capacitor 100 is constructed. Heat treatment is carried out in the process of forming the insulating film 14 or the process of forming the upper electrode 16, but since the nitrogen-rich layer 118 is formed on the lower electrode 112, the oxidation of an upper surface of the lower electrode 112 is effectively inhibited.

Incidentally, for the upper electrode 16, polysilicon is also usable instead of a metal material such as titanium nitride or aluminum. Further, as the insulating film 14, usable is a silicon oxynitride film, tantalum oxide, aluminum oxide, or the like, instead of the silicon oxide film

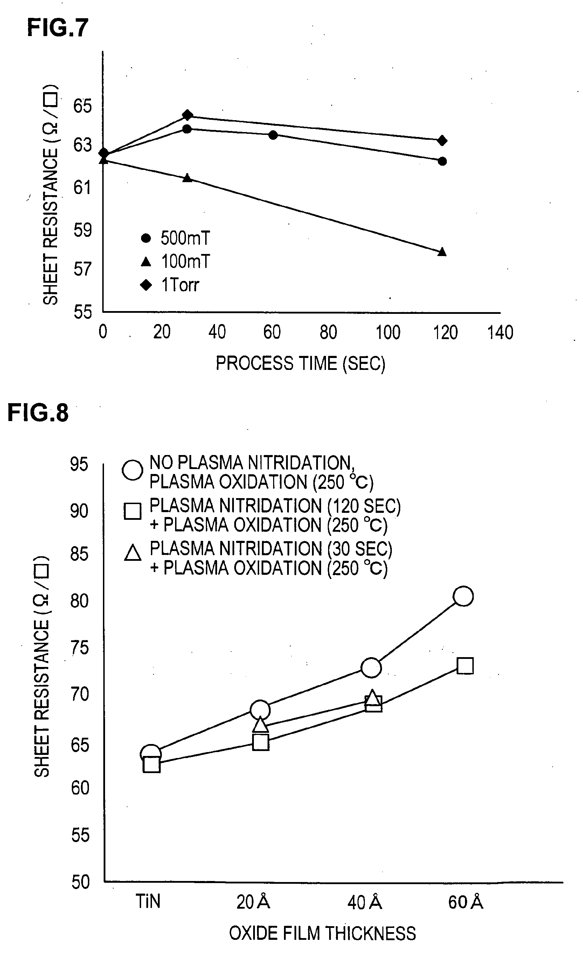

FIG. 7 shows the correlation between the process time of the plasma nitridation processing of the lower electrode 112 and its sheet resistance. As shown in the graph in FIG. 7, measurements were separately conducted under the gas pressure of 1 Torr (133 Pa), 100 mT (13.3 Pa), and 500 mT (13.3 x 5 Pa). As a result, the sheet resistance becomes lower as the gas pressure of nitrogen is lower. That is, it is seen that the nitrogen-rich layer 118 can be formed more efficiently as the gas pressure is lower.

Next, oxidation resistance of the titanium nitride film at the time of the heat treatment was studied. Samples were prepared in each of which a nitrogen-rich layer was formed by applying plasma nitridation processing to a titanium nitride film after the titanium nitride film was formed on a silicon substrate. As the samples according to the present invention, two kinds were prepared, namely, a sample to which the plasma nitridation processing was applied for 120 seconds (□ in FIG. 8) and a sample to which the plasma nitridation processing was applied for 30 seconds (○ in FIG. 8). Also prepared for comparison was a substrate having only a titanium nitride film to which no plasma nitridation processing was applied (Δ in FIG. 8).

In this experiment, the sheet resistance was measured while the plasma oxidation processing was applied, and the effect of the plasma nitridation processing was studied. FIG. 8 shows the measurement result. In the graph in FIG. 8, the vertical axis represents a sheet resistance value of the titanium nitride film (lower electrode 112). The horizontal axis represents a reference value (TiN as depo) before the plasma oxidation processing was applied, and 20 angstroms, 40 angstroms, and 60 angstroms as an oxide film thickness when the plasma oxidation processing was applied to a silicon substrate cleaned with hydrofluoric acid. The larger oxide film thickness indicates the longer time of the plasma oxidation processing. It is seen from this graph that as the plasma oxidation proceeds, the sample not having undergone the plasma nitridation processing exhibits an increase in sheet resistance value and thus is significantly effected by the oxidation of the heat treatment. On the other hand, the samples having undergone the plasma nitridation processing exhibit a small increase in sheet resistance value and thus are less susceptible to the effect of the oxidation by the heat treatment. That is, the result shows that the samples having undergone the plasma nitridation processing are superior in oxidation resistance at the time of the heat treatment.

Next, the effect of pressure in the plasma nitridation processing was studied. In order to increase a surface area, a capacitor sometimes has a three-dimensional structure having deep holes or having a rugged shape. In such a case, difference in film thickness is liable to occur depending on each portion. It is important to make the film thickness uniform since difference in film thickness leads to difference in electric property, and according to the findings by the present inventors, it has been confirmed that pressure at the time of the plasma nitridation effect uniformity in film thickness especially in a capacitor having such a three dimensional structure.

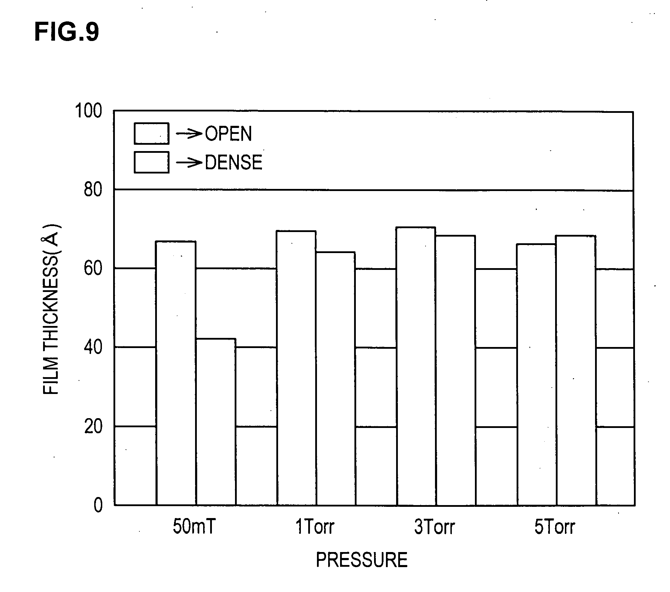

FIG. 9 shows film thickness when in a capacitor whose Si lower electrode has a rugged surface, plasma nitridation processing was applied to the lower electrode with pressure at the time of the plasma processing being varied. Open in the drawing means a case where the ruggedness of the surface of the lower electrode is sparse, and Dense means a case where the ruggedness of the surface of the lower electrode is dense, each of them showing film thickness at a bottom of a recessed portion.

From the result, it can be confirmed that uniformity in film thickness depends on pressure at the time of the plasma nitridation processing, and according to the findings of the present inventors, the pressure is preferably within a range from 1 Torr (133 Pa) to 5 Torr (5 x 133 Pa), more preferably about 3 Torr (3 x 133 Pa).

In the foregoing, the embodiments and examples are described based on several instances, but the present invention is not limited to these embodiments, and can be modified within a range of the technical idea shown in the claims.

### [Industrial Applicability]

It is possible to manufacture a thin-film capacitor without lowering its capacity, which is helpful for manufacture of semiconductor devices, for example, DRAMs..

## Claims

**1.** A semiconductor device having a capacitor, **characterized in that**:
the capacitor includes a lower electrode, an upper electrode, and an insulating film interposed between the lower electrode and the upper electrode, and
a surface of the lower electrode on an insulating layer side is nitrided.

**2.** The semiconductor device according to claim 1, **characterized in that**
the lower electrode is made of polysilicon.

**3.** The semiconductor device according to claim 1, **characterized in that**
the lower electrode is made of titanium nitride and a surface of the titanium nitride is further nitrided.

**4.** The semiconductor device according to claim 1, **characterized in that**
the lower electrode is nitrided by plasma processing.

**5.** The semiconductor device according to claim 1, **characterized in that**
the capacitor is used in a DRAM.

**6.** The semiconductor device according to claim 1, **characterized in that**
the capacitor is used in a logic device.

**7.** A manufacturing method of a semiconductor device, comprising the steps of:
forming a lower electrode for a capacitor on a semiconductor substrate;
nitriding a surface of the lower electrode;
forming an insulating film on the lower electrode; and
forming an upper electrode on the insulating film.

**8.** The manufacturing method according to claim 7, **characterized in that**
the lower electrode is made of polysilicon.

**9.** The manufacturing method according to claim 7, **characterized in that** the lower electrode is made of titanium nitride, and the method further comprising the step of further nitriding a surface of the titanium nitride.

**10.** The manufacturing method according to claim 7, **characterized in that**
the lower electrode is nitrided by plasma processing.

**11.** The manufacturing method according to claim 7, **characterized in that**
the capacitor is for a DRAM.

**12.** The manufacturing method according to claim 7, **characterized in that**
the capacitor is for a logic device.

**13.** A semiconductor manufacturing apparatus used in manufacturing steps of a capacitor having an upper electrode, a lower electrode, and an insulating film formed between the upper electrode and the lower electrode, the apparatus comprising:
a process vessel housing a semiconductor substrate to be processed;
a gas supply means for supplying gas appropriate for processing into the process vessel; and
a microwave supply means for supplying a microwave into the process vessel in order to excite a plasma, and the apparatus **characterized in that**
in order to form a nitride film on a surface of the lower electrode, the gas supply means supplies nitrogen gas into the process vessel after the semiconductor substrate on which the lower electrode is formed is loaded in the process vessel.

**14.** The manufacturing apparatus according to claim 13, **characterized in that**
the lower electrode is made of polysilicon.

**15.** The manufacturing apparatus according to claim 13, **characterized in that**
the lower electrode is made of titanium nitride, and a surface of the titanium nitride is further nitrided.

**16.** The manufacturing apparatus according to claim 13, **characterized in that**
the capacitor is for a DRAM.

**17.** The manufacturing apparatus according to claim 13, **characterized in that**
the capacitor is for a logic device.

**18.** The manufacturing method according to claim 10, **characterized in that**
the plasma processing is carried out under a reduced pressure of 1 Pa to 5 x 133 Pa or lower.

**19.** A computer recording medium containing software based on which a computer causes a semiconductor manufacturing apparatus to execute the steps of:
forming a lower electrode for a capacitor on a semiconductor substrate;
nitriding a surface of the lower electrode;
forming an insulating film on the lower electrode; and
forming an upper electrode on the insulating film.
